# EUROPEAN PATENT SPECIFICATION

(11) **EP 2 744 002 B1**
(45) Date of publication and mention of the grant of the patent: **05.08.2015**
(21) Application number: 12197333.3
(22) Date of filing: 14.12.2012
(51) Int. Cl.: H01L 43/08, H01F 10/00, G11C 11/16, H01F 10/32

(54) **Memory device**
Speichervorrichtung
Dispositif de mémoire

(43) Date of publication of application: 18.06.2014
(73) Proprietor: Hitachi, Ltd., Tokyo (JP)
(72) Inventor: Wunderlich, Joerg, Cambridge, Cambridgeshire CB3 0HE (GB); Marti, Xavier, 162 53 Praha 6 (CZ); Jungwirth, Tomas, 162 53 Praha 6 (CZ)
(74) Representative: Piotrowicz, Pawel Jan Andrzej

(56) References cited:
- WO-A1-2006/003639
- SCHMALHORST J ET AL: "Switching stability of magnetic tunnel junctions with an artificial antiferromagnet", APPLIED PHYSICS LETTERS, AIP, AMERICAN INSTITUTE OF PHYSICS, MELVILLE, NY, US, vol. 77, no. 21, 20 November 2000 (2000-11-20), pages 3456-3458, XP012026733, ISSN: 0003-6951, DOI: 10.1063/1.1327272
- B. G. PARK ET AL: "A spin-valve-like magnetoresistance of an antiferromagnet-based tunnel junction", NATURE MATERIALS, vol. 10, no. 5, 1 May 2011 (2011-05-01), pages 347-351, XP055060585, ISSN: 1476-1122, DOI: 10.1038/nmat2983
- WANG L ET AL: "Magnetoresistance effect in antiferromagnet/nonmagnet/antiferromagnet multilayers", APPLIED PHYSICS LETTERS, AIP, AMERICAN INSTITUTE OF PHYSICS, MELVILLE, NY, US, vol. 95, no. 15, 14 October 2009 (2009-10-14), pages 152512-152512, XP012126081, ISSN: 0003-6951, DOI: 10.1063/1.3248223

## Description

The present invention relates to a memory device.

Magnetoresistive random-access memory (MRAM) is becoming increasingly used as solid-state non-volatile memory.

A typical MRAM cell includes two ferromagnetic layers separated by a thin, non-magnetic insulating layer which provides a tunnel barrier. One ferromagnetic layer, usually referred to as a "pinned layer" or "reference layer", has a magnetization whose orientation is fixed. The other ferromagnetic layer, generally referred to as the "free layer", has a magnetization whose orientation can be switched so as to be parallel or anti-parallel to the orientation of the magnetization in the pinned layer. Switching can be achieved by applying an external magnetic field or by passing a current having a sufficiently high current density in a process known as "spin torque transfer" (STT) switching. The parallel and anti-parallel states have high and low resistances respectively and, thus, can be used to store a bit of information. An overview of spin electronics, including MRAM, can be found in C. Chappert, A. Fert, and F. N. Van Dau: "The emergence of spin electronics in data storage" Nature Materials, volume 6, pages 813 to 823 (2007).

Another form of magnetoresistive device is a tunnelling anisotropy magnetoresistance (TAMR) device, as described in C. Gould et al.: "Tunneling Anisotropic Magnetoresistance: A Spin-Valve-Like Tunnel Magnetoresistance Using a Single Magnetic Layer", Physical Review Letters, volume 93, page 117203 (2004). In a TAMR device, one of the ferromagnetic layers is replaced with a non-magnetic conductive layer. Magnetoresistance arises as a result of an anisotropy in local density of states at the interface between the tunnel barrier and the ferromagnetic layer.

As described in EP 2 065 886 A1, TAMR can be increased by including a thin layer of platinum or other transition metal between the non-magnetic insulating layer and the ferromagnetic layer.

B. G. Park et al.: "A spin-valve-like magnetoresistance of an antiferromagnet-based tunnel junction", Nature Materials, volume 10, pages 347 to 351 (2011) describes another TAMR-like device having a multi-layer stack formed by a layer of nickel-iron (NiFe), a layer of iridium manganese (IrMn), a layer of magnesium oxide (MgO) and a layer of platinum (Pt). The MgO layer provides a tunnel barrier between antiferromagnetic IrMn and non-magnetic Pt. Ferromagnetic moments in the NiFe layer are reversed by an external magnetic field and the exchange-spring effect of NiFe on the IrMn layer induces rotation of the antiferromagnetic moments in IrMn layer.

The ferromagnetic NiFe layer is exchange-coupled to the antiferromagnetic IrMn layer to form an exchange spring. The ferromagnetic NiFe layer allows weak magnetic fields (i.e. of the order of the magnetic anisotropy fields in typical magnets) to rotate the antiferromagnetic moments. However, this arrangement limits the thickness of the IrMn layer to dimensions not exceeding the domain wall width in the antiferromagnet. Since the exchange spring triggers rotation of the antiferromagnetic moments at the opposite interface to the antiferromagnet /tunnel barrier interface, an antiferromagnetic TAMR effect is observable in antiferromagnetic films which are thinner than the domain wall width in the antiferromagnet.

Recent experiments have demonstrated that room-temperature antiferromagnetic TAMR can be realized in the exchange spring tunnel junctions in a narrow window of antiferromagnetic layer thicknesses. In such tunnel junctions, the antiferromagnetic layer should be thin enough to allow for the exchange spring rotation of antiferromagnetic moments across the entire width of the antiferromagnet, while being thick enough to avoid the suppression of the Néel temperature, T_{N}, below room temperature due to size effects.

WO 2006/003639 A1 discloses a tunnel magnetoresistance device. The device comprises a film laminate having two electrode layers separated by a thin dielectric layer. At least one of the layers is of a ferromagnetic material.

According to a first aspect of the present invention there is provided a memory device comprising an antiferromagnet, an insulator and an electrode arranged in a tunnel junction configuration. The memory device does not include a ferromagnet.

Thus, stray magnetic fields produced by the memory device can be minimised and may even be eliminated. Moreover, the antiferromagnet can store information more robustly such that it has greater resilience to magnetic field perturbation.

The antiferromagnet may be electrically conductive.

The antiferromagnet may comprise an alloy. The antiferromagnet may comprise a multilayer.

The antiferromagnet may comprise an alloy which includes and/or a multilayer which includes a layer of manganese (Mn).

The antiferromagnet may comprise an alloy which includes and/or a multilayer which includes a layer of a transition metal. The transition metal may be chromium (Cr), iron (Fe), cobalt (Co), iridium (Ir), nickel (Ni) or palladium (Pd). The alloy may include manganese (Mn). For example, the alloy may comprise iridium manganese (IrMn).

The antiferromagnet may comprise an alloy which includes and/or a multilayer which includes a layer of a post-transition metal. The post-transition metal may be bismuth (Bi). The alloy may include manganese (Mn). For example, the alloy may comprise bismuth manganese (BiMn).

The antiferromagnet may comprise an oxide and/or a multilayer which includes a layer of an oxide. The oxide may be a transition metal oxide. The transition metal oxide may be chromium oxide (CrO), nickel oxide (NiO) or copper oxide (CuO).

The antiferromagnet may comprise a semiconductor and/or a multilayer which includes a layer of a semiconductor. The semiconductor may be a ternary alloy comprising a group 1 or group 11 element, a group 7 element and a group 15 element. The ternary alloy may be lithium manganese arsenide (LiMnAs), copper manganese arsenide (CuMnAs) or copper manganese phosphide (CuMnP).

The ternary alloy may be lithium manganese arsenide (LiMnAs), copper manganese arsenide (CuMnAs) or copper manganese phosphide (CuMnP).

The antiferromagnet may comprise a semimetal and/or a multilayer which includes a layer of a semimetal.

The antiferromagnet may take the form of layer, for example, a patterned layer. The antiferromagnet may have a thickness of at least 1 nm, at least 2 nm, at least 5 nm, at least 10 nm or more. The antiferromagnet may have a thickness no more than 10 nm, no more than 20 nm, no more than 50 nm, no more than 100 nm or more.

The memory device may comprise a non-ferromagnetic support and the antiferromagnet may be formed directly on the non-ferromagnetic support.

The non-ferromagnetic support may comprise at least one seed layer for providing an atomically-smooth surface directly supporting the antiferromagnet. The at least one seed layer may include a multi-layer stack comprising two or more layers of tantalum (Ta) and at least one layer of ruthenium (Ru) each ruthenium layer interposed between two tantalum layers.

The memory device may comprise a further electrode for providing electrical contact to the antiferromagnet. If present at least one seed layer is present, the at least one seed layer may be interposed between the antiferromagnet and the further electrode.

The memory device may further comprise a substrate supporting the antiferromagnet, insulator and electrode. The memory device may comprise a multilayer stack upstanding from the substrate.

The electrode may be non-ferromagnetic. The electrode may comprise a normal metal or a normal semiconductor. The electrode may comprise a transition metal, such as tantalum (Ta) or platinum (Pt). Using platinum or other transition metals can result in large changes in density of states and, thus, a greater magnetoresistance. The electrode may comprise an antiferromagnet. If the easy axes of the antiferromagnet and the electrode are different, then this can result in a greater magnetoresistance.

The insulator may comprise an oxide, such as magnesium oxide. The insulator may be crystalline, for example, crystalline magnesium oxide.

The insulator may take the form of layer. The insulator may have a thickness of at least 0.5 nm, at least 1 nm, at least 2 nm or at least 5 nm. The insulator may have a thickness no more than 5 nm, no more than 10 nm.

The insulator may be antiferromagnetic. For example, insulator may comprise antiferromagnetic oxide of a transition metal, such as chromium or nickel.

According to a second aspect of the present invention there is provided apparatus comprising the memory device, means for controlling temperature of the antiferromagnet and means for applying a magnetic field to the antiferromagnet.

The temperature controlling means may comprise a cryostat or refrigerator. The temperature controlling means may comprise a thermoelectric cooler. The temperature controlling means may include a heater, such as a resistor. The memory device and the temperature controlling means may be supported on a single substrate, for example, in the form of integrally-formed temperature controller.

The magnetic field applying means may comprise a wire or coil. The memory device and the temperature controlling means may be supported on a (or the) single substrate.

According to a third aspect of the present invention there is provided memory comprising an array of memory cells, each memory cell including the memory device, a temperature controller system and a set of magnetic field generators, each magnetic field generator configured to apply a magnetic field of first or second orientation to a respective memory device so as to configure the memory device in one of first and second metastable configurations.

The temperature controller system may comprise a thermoelectric cooler. The temperature controller system may include heater(s), such as resistor(s). The respective memory device so as to configure the memory device in one of first and second metastable configurations.

The temperature controller system may comprise a thermoelectric cooler. The temperature controller system may include heater(s), such as resistor(s). The temperature controller system and the memory may be supported on a single substrate, i.e. an "on-chip" temperature controller system may be used.

Each magnetic field generator may comprise a set of one or more wires or coils. For example, a pair of wires (or coils) may be provided for each memory device. The magnetic field generators and memory cells may be supported on a single substrate, i.e. "on-chip" magnetic field generators may be used.

The temperature control elements, such as heaters, and magnetic field generators, e.g. conductive lines may be integrated into a unitary element. For example, a line having a weak link can be used not only to generate a magnetic field but also generate heat.

According to a fourth aspect of the present invention there is provided a method of configuring the memory device, the method comprising heating the antiferromagnet to a first temperature which is sufficiently high to allow magnetic moments in the antiferromagnet to be re-oriented, applying an external magnetic field to the antiferromagnet having re-orientable magnetic moments and cooling or allowing cooling (for example, by stopping heating) of the antiferromagnet to a second, lower temperature. The magnetic field can be applied while the antiferromagnet is being cooled or cooling or for part of the time that the antiferromagnet is being cooled or cooling.

The first temperature may be at or above the Néel temperature of the antiferromagnet. Susceptibility tends to peak at the Néel temperature. However, the first temperature may be below the Néel temperature, provided that susceptibility is large enough for magnetic moments in the antiferromagnet to be re-orientated.

The second temperature may below the Néel temperature of the antiferromagnet.

Certain embodiments of the present invention will now be described, by way of example, with reference to the accompanying drawings in which:
Figure 1 is a schematic diagram of a multilayer structure including an antiferromagnetic layer which is not coupled to any ferromagnetic layer;
Figure 2 schematically illustrates a device formed from the multilayer structure shown in Figure 1 which includes an antiferromagnet which is not coupled to any ferromagnet;
Figure 3 schematically illustrates a disordered moment distribution state and first and second ordered moment distribution states corresponding to two different antiferromagnetic tunnel junction resistances;
Figure 4 schematically illustrates apparatus for configuring and measuring the antiferromagnet shown in Figure 2;
Figure 5 is a process flow diagram of a method of configuring and measuring the antiferromagnet shown in Figure 2;
Figure 6 shows plots of tunnel resistance for field-cooling along positive and negative out-of-plane z-directions of a field and for in-plane x-direction and, in inset, a plot of stability of a state realized by field-cooling in an out-of-plane field;
Figure 7 shows a plot of differential specific heat of a 2 nm IrMn sample indicating a Néel temperature of about 173 K and a plot of temperature dependence of tunnelling magnetoresistance corresponding to the relative difference between field-cool resistance measurements in 2T fields applied along out-of-plane (z) and in-plane (x) directions;
Figure 8 schematically illustrates a memory including an array of memory cells; and
Figure 9 schematically illustrates a memory cell including an antiferromagnetic tunnel junction.

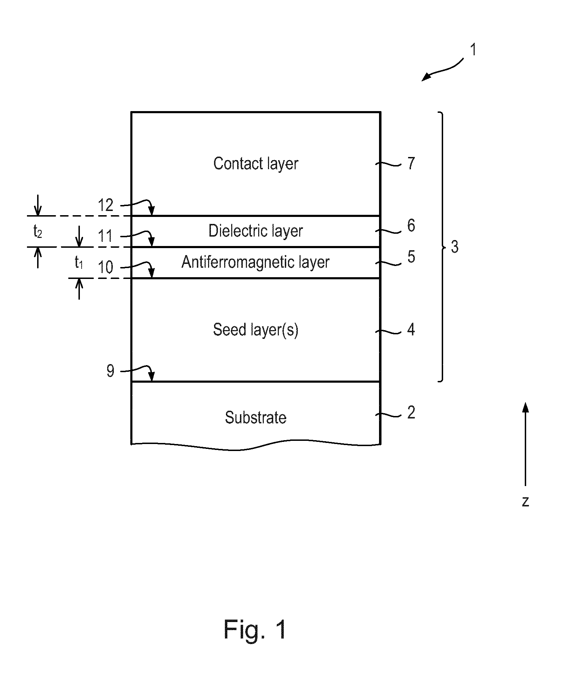

Referring to Figure 1, a heterostructure 1 (herein also referred to as a "multilayer structure") is shown. The multilayer structure 1 comprises a substrate 2 and a stack 3 of layers 4, 5, 6, 7 formed on the substrate 2. The substrate 2 can take the form of an oxidized silicon substrate, for example, 700 nm of silicon oxide (SiO₂) on (001) silicon.

The layer stack 3 is deposited under an ultrahigh vacuum by radio-frequency sputtering while a magnetic field of 5 mT is applied in an in-plane direction of the wafer 2.

A set of one or more seed layers 4 (or "buffer layers") lies on an upper surface 9 of the substrate 2. In this example, the seed layers 4 include a first layer of tantalum (Ta), a layer of ruthenium (Ru) and a second layer of tantalum (Ta). The seed layers 4 can help to control texture, microstructure and morphology of an overlying layer 5. A layer 5 of antiferromagnetic material is formed on an upper surface 10 of the seed layers 4 and has a thickness t₁. The antiferromagnetic material comprises Ir_{0.2}Mn_{0.8} and different layer structures are formed having different values of thickness t₁ ranging from 2 to 8 nm, i.e. 2 ≤ t₁ ≤ 8 nm. As will be explained in more detail later, the thickness of the antiferromagnetic material can be thicker than 8 nm, i.e. t₁ ≤ 8 nm. For example, the antiferromagnetic layer 5 can have a thickness of at least 10 nm, i.e. t₁ ≤ 10 nm. Some multilayer structures 1 are formed in which the antiferromagnetic layer 5 is thin, for example about 2 or 3 nm, so to decrease the Néel temperature of the material and so make it easier to go above and below the Néel temperature.

Other values of iridium content and manganese content can be used. Other antiferromagnetic materials can be used. For example, transition metals other than iridium can be used, such as chromium (Cr), iron (Fe), cobalt (Co), nickel (Ni) or palladium (Pd). An antiferromagnetic material alloy or an antiferromagnetic multilayer material can be used.

A layer 6 of dielectric material is formed on an upper surface 10 of the seed layers 4. The dielectric material is crystalline magnesium oxide (MgO). Magnesium oxide is deposited in amorphous form but is crystallised by annealing the multilayer structure 1 at 250°C for 1 hour while a magnetic field of 0.4 T is applied along the flat-edge direction of the wafer after the layers 4, 5, 6, 7 have been deposited. The layer 6 has a thickness t₂ which is chosen to be sufficiently thin to form a tunnel barrier. In these examples, the layer 6 has a thickness of 2.5 nm, i.e. t₂ = 2.5 nm. However, the layer 6 can be thinner or thicker as required.

Other dielectric materials such as silicon dioxide (SiO₂), aluminium oxide (Al₂O₃) or high-k dielectrics such as hafnium oxide (HfO₂) can be used. The dielectric material may be antiferromagnetic.

The antiferromagnetic layer 5 is in direct contact with the dielectric layer 6 so that modifications of its relativistic spin-orbit coupled band structure at different antiferromagnetic configurations can yield a tunnelling anisotropic magnetoresistance (AFM TAMR).

A layer 7 of conductive material overlies an upper surface 12 of the dielectric layer 6. The conductive material is tantalum (Ta). However, other metals or a semiconductor material can be used.

The heterostructure 1 does not include a layer of ferromagnetic material, such as nickel iron (NiFe). Thus, the antiferromagnetic layer 5 is not coupled (via exchange coupling) to any ferromagnetic layer or region. Expressed differently, the antiferromagnetic layer 5 is ferromagnetically decoupled.

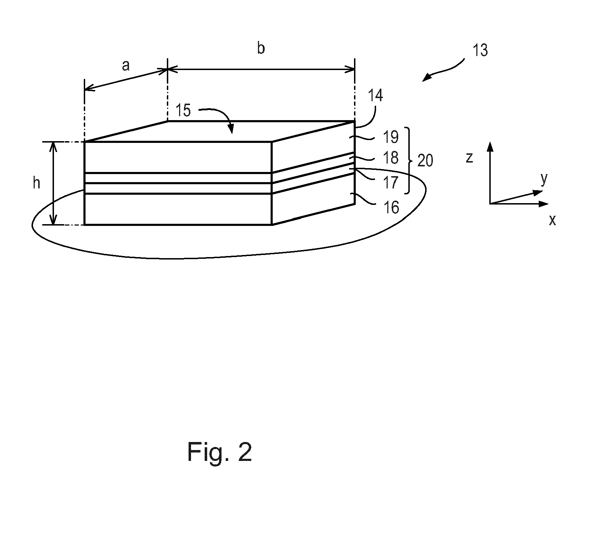

Referring also to Figure 2, devices 13 can be formed by patterning the multilayer structure 1 to form pillar structures 14 or "mesas" (for clarity only one device and one pillar structure 14 is shown in Figure 2) having an upper surface 15 and which includes a first contact 16, an antiferromagnet 17, a tunnel barrier 18 and a second contact 19 (which can be provided all or in part by the antiferromagnet 17). Suitable fabrication method steps are described in EP 2 065 886 A1.

The antiferromagnet 17, a tunnel barrier 18 and a second contact 19 form an antiferromagnetic tunnel junction 20 which can exhibit different metastable states corresponding to different spin configurations in the antiferromagnet 17.

At a temperature much lower than the Néel temperature, T_{N}, of the antiferromagnet 17, magnetic susceptibility χ of the antiferromagnet 17 is vanishingly small, i.e. zero. Thus, the antiferromagnet 17 is not polarized by the application of an external magnetic field. As temperature T increases and approaches the Néel temperature, magnetic susceptibility χ increases. At or above a temperature the Néel temperature, T_{N}, magnetic susceptibility χ tends towards infinity and the antiferromagnet 17 becomes paramagnetic. As temperature T is increased, anisotropy energy of magnetic moments in the antiferromagnet 17 decreases. Thus, at a sufficiently high temperature (but which is still below the the Néel temperature, T_{N}), reorientation of magnetic moments in the antiferromagnet 17 becomes possible and an applied external magnetic field can induce a magnetization in the antiferromagnet 17. If the antiferromagnet 17 is cooled, then orientation of magnetic moments in the antiferromagnet 17 is frozen.

The state of an antiferromagnetic tunnel junction 20 can be set by cooling the junction 20 and crossing the Néel temperature by applying external magnetic fields having different orientations. These metastable states can be detected electrically using antiferromagnetic tunnelling anisotropic magnetoresistance (AFM TAMR). Using such a field-cooling approach, the need for an exchange spring can be avoided and so a ferromagnet need not be used. This allows thicker antiferromagnetic films to be used.

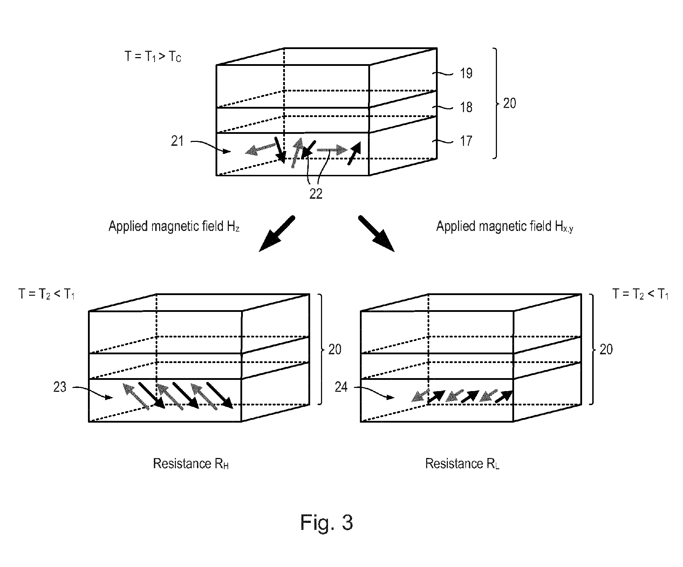

Referring also to Figure 3, starting from a disordered state 21 of spins 22 at a temperature T₁ above a critical temperature Tc (which is usually the Néel temperature T_{N}) a lower resistance state R_{L} and a higher resistance state R_{H} of the antiferromagnetic tunnel junction 20 are obtained by cooling the device 13 in magnetic fields applied perpendicular or parallel to the upper surface 15 of the device 13. The enhanced susceptibility of the antiferromagnetic material when crossing the Néel temperature T_{N} allows realization of different metastable antiferromagnetic configurations 24, 25.

Transmission electron microscopy (TEM) images (not shown) shows that the heterostructure 1 has a high structural quality. Low- and high-resolution scanning transmission electron microscopy (STEM) images (not shown) show that stacking comprises continuous films over large distances. This is consistent with atomic force microscopy analysis at intermediate growth steps which revealed that each new layer preserved a root mean square (rms) roughness of less than 1 nm.

The TEM images confirm successful re-crystallization of magnesium oxide (MgO) after the annealing step carried out at 250°C for 1 hour. The MgO dielectric layer 5 is highly textured along the out-of-plane [001] direction, parallel to the IrMn [111] texturation. This is also confirmed by X-ray diffraction measurements.

Pillar structures 14 are formed by photolithography and ion milling. The pillar structures 14 have a height, h. The height, h, is about 24 nm.

The pillars 14 are generally rectangular in cross section having sides a, b. Devices 13 having pillar structures 14 of different areas are formed. For example, one device has sides a = 1 µm and b = 2 µm. Another device has sides a = 5 µm and b = 10 µm. The pillars 14 can be circular in cross section.

The devices 13 show tunnelling I(V) characteristics and resistance-area products (RA) typical of standard MgO magnetic tunnelling junction with the same thickness.

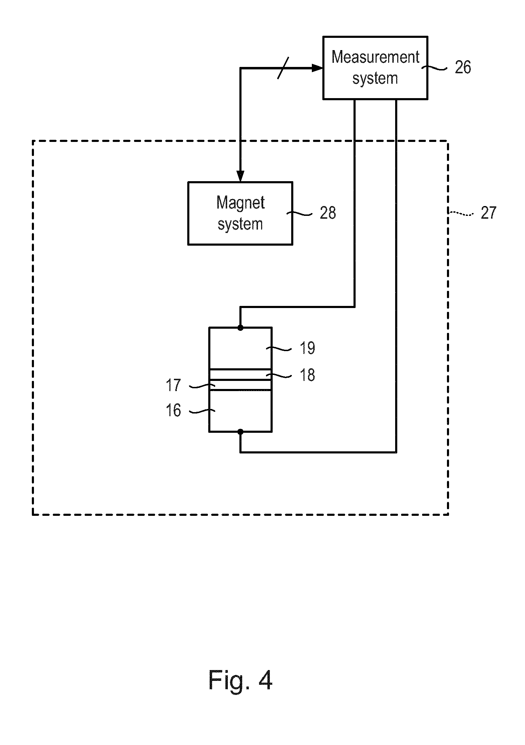

Referring to Figure 4, a Quantum Design (RTM) Physical Property Measurement System (PPMS) 26 and an Oxford Instruments cryostat 27 furnished with vector magnet 28 is used to perform the magneto-transport measurements.

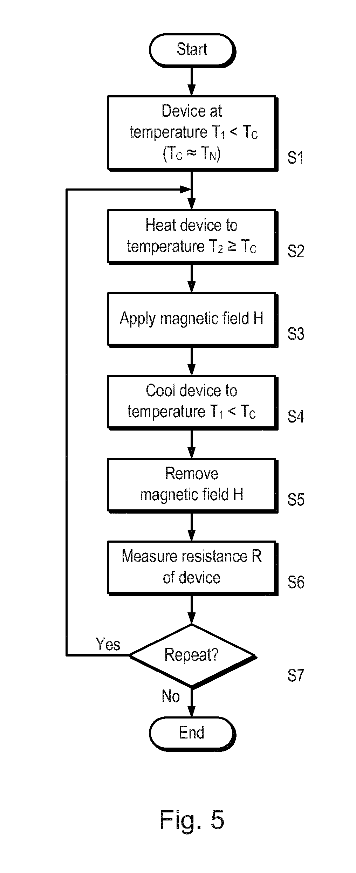

Referring also to Figure 5, a device 13 is cooled or is at, for example, base temperature, T₁, of the cryostat (step S1). The device 13 is then warmed to temperature T₂ above a critical temperature T_{C} (step S2). The critical temperature T_{C} is typically the Néel temperature T_{N} of the antiferromagnet 17. However, in some cases, realignment of spins can occur at a temperature T slightly below the Néel temperature T_{N}. A magnetic field H is applied in a given direction (step S3) and, while the magnetic field is still applied, the device 13 is cooled back to a temperature T₁ below critical temperature T_{C} so as to freeze the spins in given configuration (step S4). The resistance of the device 13 can be measured using TAMR.

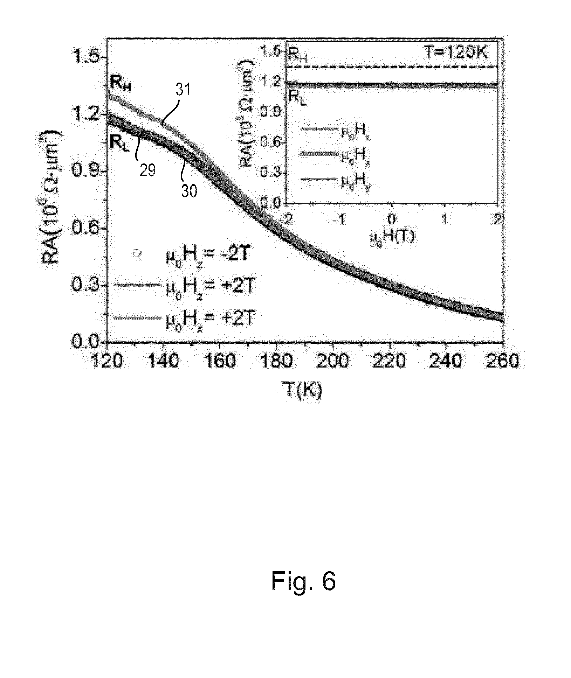

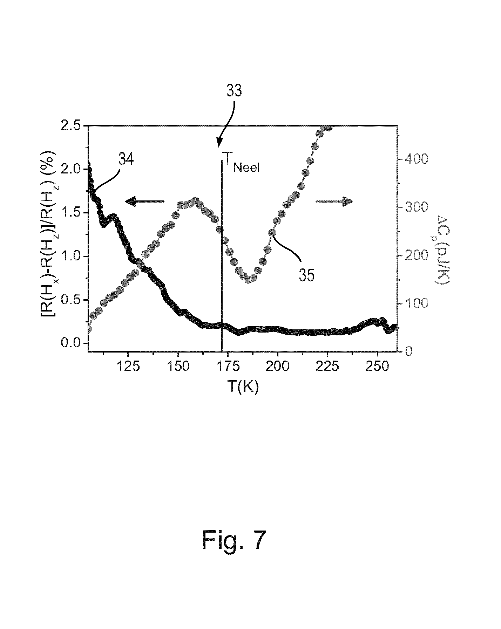

Figures 6 and 7 show experimental results for a device 13 (Figure 2) having an antiferromagnet 17 (Figure 2) formed from an Ir_{0.2}Mn_{0.8} antiferromagnetic layer 5 (Figure 1) having a thickness of 2 nm, i.e. t₁ = 2 nm.

Calorimetry measurements show that the Néel temperature T_{N} of the 2 nm-thick antiferromagnet 17 is to about 173 K. This makes it possible to perform field cooling from room temperature (about 290K) down to 120 K which covered a sufficiently large temperature range around the Néel temperature T_{N}.

In the main panel of Figure 6, plots 29, 30 of RA product against temperature for external magnetic fields µₒH_{z} of ±2T oriented perpendicular to the device surface are shown and a plot 31 of RA product against temperature for an external magnetic field µₒHₓ = +2T oriented in the plane of the sample along the [100] axis is shown.

The RA product is measured at a fixed bias of 20 mV and is identical for all three field orientations in the temperature interval from 300 K to approximately 170 K. However, below 170 K, the RA traces 29,30 for out-of-plane magnetic field orientations and the RA trace 31 for in-plane magnetic field orientation split. At 120 K, the difference is more than 10%. As shown in the inset panel of Figure 6, these states are metastable at temperatures sufficiently below T_{N}.

In the measurement, the higher resistance state was prepared by in-plane field cooling and then the temperature was stabilized at 120 K. The RA product (at 20 mV bias) was monitored while continuously sweeping the magnetic field in the out-of-plane direction (H_{z}) and also in the two orthogonal in-plane directions (Hₓ and H_{y}) between +2 T and - 2 T, for 10 hours. No changes in the tunnelling resistance are observed within the experimental noise, which is much smaller than the difference between the higher and lower resistance states observed and shown in the main panel of Figure 6. This demonstrates that a state prepared by field cooling is metastable and insensitive to relatively large external magnetic fields.

Figure 7 illustrates that the field-cool magnetotransport effect shows signatures of an anisotropic magnetoresistance. In particular, while the temperature-dependent resistance traces for the in-plane and out-of-plane fields split below T_{N}, no difference is observed between field-cool measurements performed at fields with the opposite polarity. The observed magnetoresistance is not considered to be ascribed to magnetization-independent tunnelling transport phenomena due to, for example, Lorentz force effects of the magnetic fields applied along different directions with respect to the tunnelling current direction. These types of phenomena can be excluded since the field-cooling magnetoresistance disappears above the Néel temperature T_{N} and since a negligible magnetoresistance is observed when the temperature is stabilized below the Néel temperature T_{N} as shown in the inset of Figure 6.

In Figure 7, the onset 33 of the splitting of the RA traces for cooling in fields with different directions coincides with the transition in the 2 nm IrMn film to the ordered antiferromagnetic state.

Figure 7 shows, side-by-side, a plot 34 of normalized variation of the tunnelling resistance (R(Hₓ)-R(H_{z}))/R(H_{z}) in a 2 nm IrMn pillar device 13 and a plot 35 of the differential specific heat of a 2nm IrMn layer as a function of temperature. Quasi-adiabatic nanocalorimetry (QAnC) is a technique for investigating the Néel temperature of thin IrMn films. This technique allows for a direct measurement of the specific heat of a device, enabling the observation of the critical behaviour in the specific heat near the Néel temperature T_{N}. The Néel temperature inferred from the inflexion point of the specific heat singularity is approximately 173 K, i.e., it is significantly reduced in the 2 nm IrMn film as compared to the bulk IrMn where the Néel temperature T_{N} > 1000 K. The reproducibility of the specific heat method was confirmed in different devices prepared in separate growth runs under the same growth conditions.

The correspondence between the Néel temperature T_{N} and the onset of the field-cool AFM TAMR has been confirmed by independent measurements using the PPMS and the vector magnet cryostat and studying different antiferromagnetic tunnel junctions with the same nominal layer structure. All the devices show a negligible magnetoresistance in the paramagnetic phase and a reproducible splitting of the RA traces when continuing the field-cooling below the Néel temperature T_{N} with in-plane and out-of-plane magnetic fields. The percentage difference between the two metastable resistance states obtained at 120 K varies from 2% to 10% in different antiferromagnetic tunnel junctions. The highest values were found in devices with the largest RA, consistent with the tunnelling origin of the observed phenomenon.

The microscopic mechanism which yields the field-cool TAMR in IrMn is distinct from high-field magnetotransport effects observed in iron pnictide antiferromagnetic tunnel junctions. In iron pnictide antiferromagnetic tunnel junctions, the magnetotransport effects have been ascribed to field-induced selection of structural crystal twin domains. IrMn does not undergo a crystal phase change near the Néel temperature. Therefore, it is possible to ascribe the distinct metastable states realized by field-cooling can be to distinct antiferromagnetic tunnel junctions configurations of a uniform IrMn film.

Ir₂₀Mn₈₀ is believed to have two non-collinear antiferromagnetic phases 2Q and 3Q, confining magnetic spins in the plane or yielding an out-of-plane component respectively, with an energy difference of about 0.25 mRy/atom and a collinear phase whose energy is about 1.25 mRy/atom higher (1 Ry ≈ 13.605 eV ≈ 2.180 · 10⁻¹⁸ J).

Therefore, depending on the direction and strength of the applied field, the field-cooling procedure starting from temperatures above the Néel temperature T_{N} can favour spin configurations with different proportion of these distinct metastable antiferromagnetic phases.

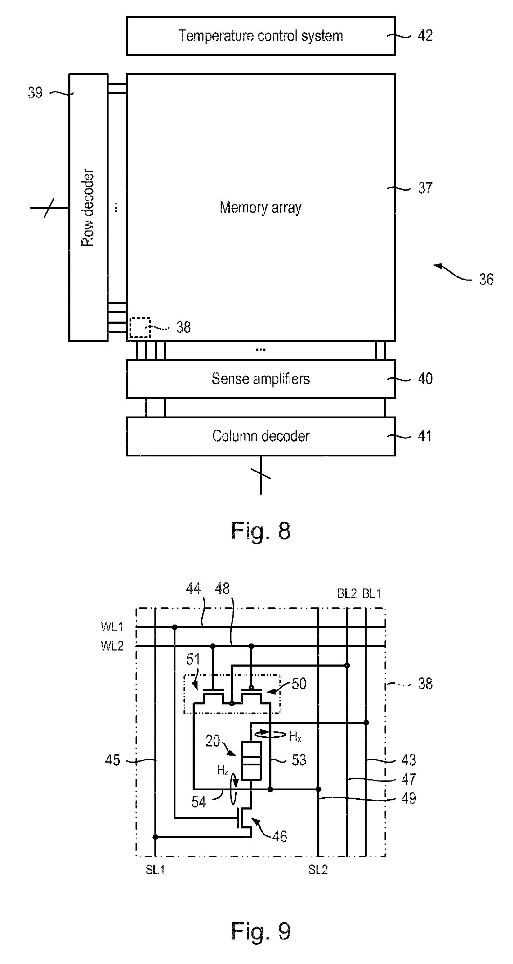

Referring to Figure 8, a non-volatile memory 36 is shown. The memory 36 includes an array 37 of cells 38, a row decoder 39, sense amplifiers 40, a column decoder 41 and a temperature control system 42.

The temperature control system 42 can be configured to heat individual cells 38, several cells 38 and/or the whole array 37.

The temperature control system 42 can include resistors or other heat-generating elements (not shown).

Self-heating arrangements can be used. For example, a conductive line used to generate a magnetic field can include a weak link (i.e. a resistive section) which heats up when a current is passed through the line. Thus, the conductive line can be used not only to generate a magnetic field, but also to heat the antiferromagnet. Additionally or alternatively, internal heat generation arising from Joule heating when a current is passed through an antiferromagnetic tunnel junction can be used to heat the antiferromagnet.

The temperature control system 42 can include thermoelectric cooling devices (not shown).

Referring also to Figure 9, a memory cell 38 is shown. The memory cell 38 includes an antiferromagnetic tunnel junction 20.

The memory cell 38 can be selected and the state of the cell 38 can be read using a first bit line 43, a first word line 44 and first select line 45 using a transistor 46 whose channel is arranged in series between the antiferromagnetic tunnel junction 20 and the select line 45 and which is controlled by the first word line 44.

The state of the cell 38 can be set using a second bit line 47, a second word line 48 and second select line 49 using a pair of transistor 50, 51 having non-inverting and inverting gates. Current through the bit line 47 can thus be selectively routed via first and second magnetic field generating lines 52, 53 which are orientated perpendicularly with respect to each other. The first magnetic field generating line 52 is used to generate a magnetic field perpendicular to the interfaces between the layers of the antiferromagnetic tunnel junction 20. The second magnetic field generating line 54 is used to generate a magnetic field parallel to the interfaces between the layers of the antiferromagnetic tunnel junction 20.

It will be appreciated that many modifications may be made to the embodiments hereinbefore described.

The device can have different dimensions. For example, a thicker antiferromagnetic layer can be used. A top contact layer which is thicker or thinner can be used. The area of the antiferromagnetic layer can be different. Other materials, for example, other antiferromagnetic materials can be used. The antiferromagnetic layer may take the form of an alloy or a multilayer.

The antiferromagnetic tunnel junction can configured differently. For example, the antiferromagnetic tunnel junction need not take the form of a vertical device formed of a stack of coextensive layers. The antiferromagnetic tunnel junction may comprise overlapping layers of different areas. The device may include a planarising dielectric to contact the top of the device. A highly conductive contact pad, for example comprising gold, may be provided.

Other different memory array arrangements and memory cell arrangements may be used.

The critical temperature, Tc, may exceed room temperature (i.e. about 293 K).

A cryostat or other cooling system may not be required.

T₁ may be room temperature. T₂ may be about 373 K or more.

## Claims

1. A memory device comprising an antiferromagnet (17), an insulator (18) and an electrode (19) arranged in a tunnel junction configuration (20) **characterised in that** the memory device does not include a ferromagnet such that the antiferromagnet is not coupled to a ferromagnet.

2. A memory device according to claim 1, further comprising a non-ferromagnetic support, wherein the antiferromagnet (17) is formed directly on the non-ferromagnetic support.

3. A memory device according to claim 2, wherein the non-ferromagnetic support comprises at least one seed layer providing an atomically-smooth surface directly supporting the antiferromagnet.

4. A memory device according to any preceding claim, comprising an additional electrode (16) for providing electrical contact to the antiferromagnet (17).

5. A memory device according to any preceding claim, further comprising a substrate supporting the antiferromagnet (17), insulator (18) and electrode (19).

6. A memory device according to any one of claims 1 to 5, wherein the electrode (19) is non-ferromagnetic.

7. A memory device according to claim 6, wherein the electrode (19) comprises an antiferromagnet.

8. A memory device according to any preceding claim, further comprising a non-ferromagnetic layer interposed between the antiferromagnet (17) and the insulator (18).

9. A memory device according to any preceding claim, wherein the insulator (18) is antiferromagnetic.

10. Apparatus comprising:
a memory device according to any preceding claim;
means (27) for controlling temperature of the antiferromagnet (17); and
means (28) for applying a magnetic field to the antiferromagnet.

11. Memory (36) comprising:
an array (37) of memory cells (38), each memory cell including a memory device according to any one of claims 1 to 9;
a temperature controller system (41); and
a set of magnetic field generators (42), each magnetic field generator configured to apply a magnetic field of first or second orientation to a respective memory device so as to configure the memory device in one of first and second metastable configurations.

12. A method of configuring a memory device according to one of claims 1 to 10, the method comprising:
heating the antiferromagnet (17) to a first temperature (T₂) which is sufficiently high to allow re-orientation of magnetic moments (22) in the antiferromagnet;
applying an external magnetic field (H_{x,y}; H_{z}) to the antiferromagnet while magnetic moments are re-orientable; and
cooling or allowing cooling of the antiferromagnet to a second, lower temperature (T₁).

13. A method according to claim 12, wherein the first temperature (T₂) is at or above the Néel temperature (T_{N}) of the antiferromagnet (17).

14. A method according to claim 12 or 13, wherein the second temperature (T₁) is below the Néel temperature (T_{N}) of the antiferromagnet (17).

## Patentansprüche

1. Speichergerät, das einen Antiferromagnet (17), einen Isolator (18) und eine Elektrode (19) umfasst, angeordnet in einer Tunnelkontaktkonfiguration (20), **dadurch gekennzeichnet, dass** das Speichergerät keinen Ferromagnet beinhaltet, so dass der Antiferromagnet nicht mit einem Ferromagnet gekoppelt ist.

2. Speichergerät nach Anspruch 1, das ferner einen nicht ferromagnetischen Träger umfasst, wobei der Antiferromagnet (17) direkt auf dem nicht ferromagnetischen Träger ausgebildet ist.

3. Speichergerät nach Anspruch 2, wobei der nicht ferromagnetische Träger wenigstens eine Keimschicht aufweist, die eine den Antiferromagnet direkt tragende atomisch glatte Oberfläche bildet.

4. Speichergerät nach einem vorherigen Anspruch, das eine zusätzliche Elektrode (16) zum Bereitstellen eines elektrischen Kontakts mit dem Antiferromagnet (17) umfasst.

5. Speichergerät nach einem vorherigen Anspruch, das ferner ein Substrat umfasst, das den Antiferromagnet (17), den Isolator (18) und die Elektrode (19) trägt.

6. Speichergerät nach einem der Ansprüche 1 bis 5, wobei die Elektrode (19) nicht ferromagnetisch ist.

7. Speichergerät nach Anspruch 6, wobei die Elektrode (19) einen Antiferromagnet umfasst.

8. Speichergerät nach einem vorherigen Anspruch, das ferner eine zwischen dem Antiferromagnet (17) und dem Isolator (18) befindliche nicht ferromagnetische Schicht umfasst.

9. Speichergerät nach einem vorherigen Anspruch, wobei der Isolator (18) antiferromagnetisch ist.

10. Vorrichtung, die Folgendes umfasst:
ein Speichergerät nach einem vorherigen Anspruch;
Mittel (27) zum Regeln der Temperatur des Antiferromagnets (17); und
Mittel (28) zum Anlegen eines Magnetfelds an den Antiferromagnet.

11. Speicher (36), der Folgendes umfasst:
ein Array (37) von Speicherzellen (38), wobei jede Speicherzelle ein Speichergerät nach einem der Ansprüche 1 bis 9 beinhaltet;
ein Temperaturregelsystem (41); und
einen Satz von Magnetfeldgeneratoren (42), wobei jeder Magnetfeldgenerator zum Anlegen eines Magnetfelds einer ersten oder zweiten Orientierung an ein jeweiliges Speichergerät konfiguriert ist, um das Speichergerät in einer ersten oder zweiten metastabilen Konfiguration zu konfigurieren.

12. Verfahren zum Konfigurieren eines Speichergeräts nach einem der Ansprüche 1 bis 10, wobei das Verfahren Folgendes beinhaltet:
Erhitzen des Antiferromagnets (17) auf eine erste Temperatur (T₂), die hoch genug ist, um eine Neuorientierung von magnetischen Momenten (22) in dem Antiferromagnet zuzulassen;
Anlegen eines externen Magnetfelds (H_{x,y}; H_{z}) an den Antiferromagnet, während magnetische Momente neu orientierbar sind; und
Kühlen oder Kühlenlassen des Antiferromagnets auf eine zweite, tiefere Temperatur (T₁).

13. Verfahren nach Anspruch 12, wobei die erste Temperatur (T₂) auf oder über der Néel-Temperatur (T_{N}) des Antiferromagnets (17) ist.

14. Verfahren nach Anspruch 12 oder 13, wobei die zweite Temperatur (T₁) unter der Néel-Temperatur (T_{N}) des Antiferromagnets (17) ist.

## Revendications

1. Dispositif de mémoire comprenant un antiferroaimant (17), un isolant (18) et une électrode (19) agencés dans une configuration de jonction tunnel (20) **caractérisé en ce que** le dispositif de mémoire ne comporte pas de ferroaimant si bien que l'antiferroaimant n'est pas couplé à un ferroaimant.

2. Dispositif de mémoire selon la revendication 1, comprenant en outre un support non-ferromagnétique, dans lequel l'antiferroaimant (17) est formé directement sur le support non-ferromagnétique.

3. Dispositif de mémoire selon la revendication 2, dans lequel le support non-ferromagnétique comprend au moins une couche germe fournissant une surface atomiquement lisse qui supporte directement l'antiferroaimant.

4. Dispositif de mémoire selon l'une quelconque des revendications précédentes, comprenant une électrode supplémentaire (16) pour assurer un contact électrique avec l'antiferroaimant (17).

5. Dispositif de mémoire selon l'une quelconque des revendications précédentes, comprenant en outre un substrat qui supporte l'antiferroaimant (17), l'isolant (18) et l'électrode (19).

6. Dispositif de mémoire selon l'une quelconque des revendications 1 à 5, dans lequel l'électrode (19) est non-ferromagnétique.

7. Dispositif de mémoire selon la revendication 6, dans lequel l'électrode (19) comprend un antiferroaimant.

8. Dispositif de mémoire selon l'une quelconque des revendications précédentes, comprenant en outre une couche non-ferromagnétique interposée entre l'antiferroaimant (17) et l'isolant (18).

9. Dispositif de mémoire selon l'une quelconque des revendications précédentes, dans lequel l'isolant (18) est antiferromagnétique.

10. Appareil comprenant :
un dispositif de mémoire selon l'une quelconque des revendications précédentes ;
un moyen (27) pour réguler la température de l'antiferroaimant (17) ; et
un moyen (28) pour appliquer un champ magnétique à l'antiferroaimant.

11. Mémoire (36) comprenant :
une matrice (37) de cellules de mémoire (38), chaque cellule de mémoire comportant un dispositif de mémoire selon l'une quelconque des revendications 1 à 9 ;
un système de régulation de température (41) ; et
un ensemble de générateurs de champ magnétique (42), chaque générateur de champ magnétique étant configuré pour appliquer un champ magnétique d'une première ou seconde orientation à un dispositif de mémoire respectif de façon à configurer le dispositif de mémoire dans l'une de première et seconde configurations métastables.

12. Procédé de configuration d'un dispositif de mémoire selon l'une quelconque des revendications 1 à 10, le procédé comprenant :
le chauffage de l'antiferroaimant (17) à une première température (T₂) qui est suffisamment élevée pour permettre la réorientation de moments magnétiques (22) dans l'antiferroaimant ;
l'application d'un champ magnétique externe (H_{x,y}, H_{z}) à l'antiferroaimant pendant que les moments magnétiques sont réorientables ; et
le refroidissement ou le refroidissement naturel de l'antiferroaimant à une seconde température inférieure (T₁).

13. Procédé selon la revendication 12, dans lequel la première température (T₂) est égale ou supérieure à la température de Néel (T_{N}) de l'antiferroaimant (17).

14. Procédé selon la revendication 12 ou 13, dans lequel la seconde température (T₁) est inférieure à la température de Néel (T_{N}) de l'antiferroaimant (17).
